Europäisches Patentamt

European Patent Office

Office européen des brevets

(19)

(11) Publication number: **0 014 444**
**B1**

(12)

# EUROPEAN PATENT SPECIFICATION

(45) Date of publication of patent specification: **16.05.84**

(21) Application number: **80100515.8**

(22) Date of filing: **01.02.80**

(51) Int. Cl.³: **B 32 B 29/00, H 05 K 1/03, H 01 B 3/48**

(54) Insulating laminate.

(30) Priority: **02.02.79 JP 11780/79**

(43) Date of publication of application:
**20.08.80 Bulletin 80/17**

(45) Publication of the grant of the patent:
**16.05.84 Bulletin 84/20**

(84) Designated Contracting States:
**BE DE FR GB IT NL**

(56) References cited:
DE-A-2 411 154
FR-A-1 367 824
GB-A- 743 900
GB-A- 816 982

The file contains technical information
submitted after the application was filed and
not included in this specification

(73) Proprietor: KANEGAFUCHI KAGAKU KOGYO
KABUSHIKI KAISHA
2-4 Nakanoshima 3-chome
Kita-ku Osaka-shi (JP)

(72) Inventor: Oizumi, Masayuki
2-34, Yoshida-cho 1-chome Hyogo-ku
Kobe city Hyogo (JP)
Inventor: Goto, Masana
4-23, Suehiro 3-chome
Miki City Hyogo (JP)
Inventor: Ishiki, Minoru
2-29, Yoshida-cho 1-chome
Hyogo-ku Kobe City, Hyogo (JP)
Inventor: Uozumi, Shoji
2-25, Yoshida-cho 1-chome
Hyogo-ku Kobe City, Hyogo (JP)

(74) Representative: Patentanwälte TER MEER -
MÜLLER - STEINMEISTER
Triftstrasse 4
D-8000 München 22 (DE)

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

Courier Press, Leamington Spa, England.

EP 0 014 444 B1

# O 014 444

**Description**

## Background of the Invention

The invention of this application relates to copper clad laminates for printed circuit board use on the basis of a laminate comprising a plurality of reinforcements made of cellulosic paper impregnated with a cured resin selected from an unsaturated polyester type resin or epoxy type resin.

The expression "copper clad laminates" comprises boards for producing electric printed circuits to equip electric components. Conventional copper clad laminates are manufactured by impregnating a reinforcement or reinforcing material with a thermosetting resin, such as by impregnating paper with a phenolic resin or an epoxy resin or glass cloth with an epoxy resin, producing prepregs from the resin impregnated reinforcement, laminating the prepregs and a metallic foil, for example electrolytic copper foil, on one or both sides of the laminated prepregs, and hardening them by pressing and heating.

From GB—A—743 900 a method for making a laminated material and the laminated sheet or block material obtained thereby is known. The method consists in superimposing a number of sheets of vulcanized fibre with adjacent sheets laid-cross-grained and with a thin layer or coating of an adhesive between adjacent sheets, and subjecting the pack of sheets to pressure to bond them into a single sheet or block. This method is carried out to provide a product having a good mechanical strength and electrical insulating properties and low moisture absorption. Even in view of the fact, that the moisture absorption of the material can be reduced, the man of the art trying to improve the characteristics of copper clad laminates for printed circuit board use would refrain from using sheets of vulcanized fibre, since this material is definitely unsuited for printed circuit boards, because even the reduced moisture absorption would still be too high, so that the characteristics of the boards obtained would rapidly deteriorate during the use under the severe conditions of a printed circuit board, in for example a television set. According to a further embodiment of this document a combination of vulcanized fibre sheets and paper base sheets can be used. According to this embodiment the paper base sheets are in any case impregnated either with a thermosetting resin or with a thermoplastic resin. The sheets of vulcanized fibre and the impregnated paper base sheets are then bonded into a single sheet or block by using an adhesive, which may be of a cold-setting type, in which case the bonding may be effected by pressure alone, or alternatively of a hot-setting type, which will be bonded by subjecting it to both heat and pressure. It is therefore obvious that this document covers the use of different materials for impregnating the paper sheets and for bonding the paper sheets and the sheets of vulcanized fibre and that in any case pressure is used for bonding the material.

GB—A 816 982 discloses an electric insulating material and a method for its production. The electric insulating material consists of a laminated body comprising a plurality of layers of an absorbant sheet material impregnated with a permanently liquid dielectric and bonded together to form a solid body containing the liquid dielectric by means of irreversibly hardened synthetic resin, which may be an epoxy resin or an unsaturated polyester resin. As liquid dielectrics mineral oils, particularly transformer oil, liquid chlorodiphenyls or fluoro carbons are used. In view of this the material does not seem to be usable for printed circuit board use.

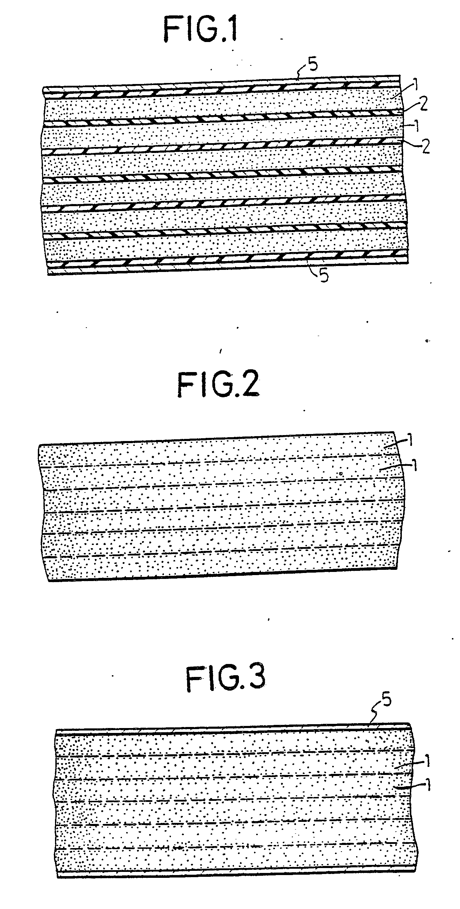

Conventional insulating laminates for electric use for example insulating laminates containing phenolic resin and paper manufactured as described above have the construction as illustrated in Fig. 3. Conventional metal clad laminates usually have a cross section similar to that shown in Fig. 4. Precise examinations have shown that the plural layers of paper of the laminates, which are impregnated with the resin are not isolated from each other because of an entanglement of fibres between each of the layers 1. It is well known that the electric insulation, the heat resistance and the stability of dimension of insulating laminates for electric use and metal clad laminates for printed circuit boards are apt to be harmed when the laminates are exposed to moisture or absorb water, which leads to unfavorable results in practical use. Usually water soaks from a surface layer into the laminates, which is facilitated by the fibers of the paper which construct the laminates and by the boundary area between fiber and resin.

The electric insulating resistances are compared in humid atmosphere in the following two cases: (1) the surface of laminates as shown in Fig. 2 where paper fibers appear on the surface and, (2) the surface of laminates as shown in Fig. 3. where the surface thereof is covered with a layer of adhesive for the metal foil 5 or a layer of the same resin which is impregnating the reinforcement 1. The electric resistance of the former laminates (1) exhibits a remarkable decrease in comparison with that of the latter laminates (2). The test teaches that fibers of paper contribute to the decrease in insulating resistance, which is a main effect of water soaking into the surface layer of circuit boards.

The laminates as shown in Fig. 3 are manufactured by a process as disclosed in the Japanese unexamined patent specification SHO.48—31265. The characteristics of the laminates as shown in Fig. 3 in humid atmosphere are to a certain extent improved and the soaking of water is temporarily prevented. However said laminates do not settle the problem satisfactorily because the resin layer is provided only at the surface, and the water having passed through the resin layer easily soaks into the laminate. Therefore once water has entered the surface layer, conventional laminates, as illustrated in Figs. 2 and 3, easily permit the soaking of water into the inner portion of the laminate along continuous fibers extending from the surface to the inner portion of the laminate. Laminates having a

2

**0 014 444**

construction as that of conventional laminates are apt to absorb moisture and water, which remarkably decreases the electric insulation properties, especially the ratio of electric volume resistance and ratio of electric isolating resistance as defined by the Japanese industrial standard JIS—C—6418. The absorbed moisture harms heat resistance necessary to endure the heat of solder, and in the case of metal clad insulating laminates for printed circuit the moisture absorbed in the reinforcement swells the laminates, lessens the stability of dimension and leads to a warping of the laminates.

Summary of the Invention.

The laminates of present invention do not have such a construction as the conventional laminates, where the reinforcements are laminated each directly face to face making a substantially integral body in cross section.

The present invention relates to copper clad laminates for printed circuit board use on the basis of a laminate comprising a plurality of reinforcements made of cellulosic paper impregnated with a cured resin selected from an unsaturated polyester type resin or epoxy type resin, characterized by a laminate comprising layers of cured resin having a thickness of 1 to 100 $\mu$m existing between and extending substantially over the reinforcements, wherein the cured resin of the layers is the same as that which is impregnating the reinforcements and wherein said layers of cured resin are substantially integral with the adjacent reinforcements, which reinforcements are isolated from each other by said layers of cured resin, obtainable by excessively impregnating each of said reinforcements with a liquid curable resin having a viscosity of 0,005 to 1,5 Pas in an amount of the curable resin of more than 50% by weight based on the weight of the resulting impregnated reinforcement in order to provide a layer of the curable resin on the surface of each of the reinforcements, forming a pile of said excessively impregnated reinforcements and curing the pile while applying low pressure or substantially no pressure.

According to a preferred embodiment of the invention the reinforcements are made from linter paper or kraft paper containing predominantely cellulosic fibres.

Brief Description of the Drawings

Fig. 1 is a sectional view of a copper clad laminate of the invention.

Figs. 2 and 3 are sectional views of prior art laminates, wherein Fig. 2 shows an insulating laminate and Fig. 3 shows a metal clad laminate.

Detailed Description of the Invention

The laminates of the present invention have a sectional view as shown in Fig. 1. Several layers of reinforcement 1 impregnated with a curable resin such as thermosetting resin are laminated. Between each layer of reinforcement, there is a layer 2 of cured resin which is the same kind of resin as that which is impregnating the reinforcement 1. The outer surfaces of the outermost reinforcements are provided with surface layers of cured resin. As the reinforcements 1 are isolated from each other by the layers 2 of cured resin, which are located and spread between the reinforcements 1, water or moisture is prevented to soak deep into the reinforcements 1 by the layer 2 of resin which is located between the first and second reinforcement. In the same manner the soaking of water into the inner portion of the reinforcements is prevented by each of the layers 2 of resin.

In the laminate of this invention, the soaking of water into the reinforcement 1 is decreased for the above mentioned reason, and the degradation of the characteristics of the laminate caused by soaked moisture and water is considerably reduced.

The curable resin used for impregnating the reinforcements 1 and for the layers 2 of cured resin formed between each reinforcement 1 are conventional known curable resins such as epoxy or unsaturated polyester resins. The same kind of resin is used throughout all layers 2. The resin throughout all layers 2 and the resin impregnating the reinforcement 1 is the same. The reinforcements 1 are made from cellulosic paper such as linter paper or kraft paper containing predominantly cellulose fibres. Because paper is the material which is predominantly apt to soak moisture, a remarkable improvement of the insulting character of laminates can be obtained with this invention.

The copper clad laminate according to the present invention is obtainable by excessively impregnating each of said reinforcements of a liquid curable resin having a viscosity of 0,005 to 1,5 Pas in an amount of the curable resin of more than 50% by weight based on the weight of the resulting impregnated reinforcement in order to provide a layer of the curable resin on the surface of each of the reinforcements, forming a pile of said excessively impregnated reinforcements and curing the pile while applying low pressure or substantially no pressure. Preferably the reinforcements are impregnated with excessive resin and are passed through the opening of a slit device, the opening of the slit of which is determined by the thickness of the reinforcement, the number of the reinforcements to be piled up or the thickness of the resin layer located between the reinforcements, whereafter the reinforcements are piled up to form a piled body which is then cured by heating. In this way the quantity of resin existing between the layers of reinforcements can be controlled and the desired construction of the laminate can be obtained by curing without applying pressure. It is well known that a thermosetting resin impregnating a reinforcement contracts somewhat during the curing process in the reinforcement.

3

Therefore a small vacant space between layers of reinforcements impregnated with resin happens to be produced because of the contraction of the resin during the curing process without applying pressure.

In case the resin is liquid at room temperature, such as epoxy or unsaturated polyester resins, the laminates are manufactured by applying the resin to each resin-impregnated reinforcement at the time the reinforcements are piled up or by impregnating the reinforcements with excessive resin and passing the reinforcements through the opening of a slit device, the opening of the slit of which is determined by the thickness of reinforcements, the number of the reinforcements to be piled up or the thickness of the resin layer located between the reinforcements, piling up the reinforcements to form a piled body, and curing the laminates by heating. When producing laminates by impregnating reinforcements with a thermosetting liquid resin without using a solvent, and by curing the laminated reinforcements, it is desirable that no substantial pressure is applied to the laminated reinforcements for molding the laminates. The reason why no substantial pressure should be applied is that the quantity of resin existing between layers of reinforcements can be controlled by passing several reinforcements through the slit device, and that the desired construction of the laminate can be obtained by curing without applying pressure. It is well known that a thermosetting resin impregnating a reinforcement contracts somewhat during the curing process in the reinforcement. Therefore a small vacant space between layers of reinforcements impregnated with resin happens to be produced because of the contraction of the resin during the curing process without applying pressure.

The invention prevents this problem of producing vacant spaces or cavities in the laminate and leads to favorable results. It is understood that a resinous liquid which exists between the layers of reinforcement compensates the contraction of the resin in the reinforcement during the curing process. The resin employed for layers 2 containing no solvent is suitable for carrying out this invention because the resin needs not to be dried to evaporate the solvent and in addition to that the thickness of the resin layer 2 between the reinforcements can be controlled without difficulty. The viscosity of the uncured liquid resin is also an important factor to control the layers 2 of resin located between the reinforcements 1. For this reason unsaturated polyester resins are desirable in this invention because uncured unsaturated polyester resins are in liquid state at room temperature and can be produced to have a wide range of viscosity, for example from 0,005 to 1,5 Pas. The thickness of the resin layer 2 is preferably 1 to 100 $\mu$m. An excessive thickness of the layer 2 is apt to harm the properties of the laminate, for example the punching quality. Therefore the thickness of the resin layer is preferably thinner than the thickness of reinforcement.

The existence and the thickness of the resin layer 2 can be examined exactly with an optical microscope by the conventional method of cutting a cross section of the laminate with a sharp knife, or by setting the test piece with an encapsulating resin and then cutting and polishing the section. For the copper clad laminates as shown in Fig. 1 foils are used, especially an electrolytic copper foil because of its strong adhesion. In this invention it is desirable to provide resin layers not only between each of the reinforcements but also on one or both sides of the laminate as shown in Fig. 1.

The complete isolation of the reinforcements by the intermediate resin layers 2 is naturally desirable, however the benefit of this invention is preserved even when there is some partial contact between the reinforcements 1 of the laminates.

In the following example a copper clad laminate is compared with a conventional laminate.

### Example

A liquid resin composition is prepared by blending 100 parts by weight of commercialized unsaturated polyester resin (product of Takeda Pharmaceutical Co. by Trademark Polymal 6304) and one part by weight of Cumene hydroperoxide.

The unsaturated polyester has following property:

| | |
|---|---|
| specific weight of liquid | 1,1 g/cm³ |
| viscosity at 25°C | about 0,45 Pas |
| specific weight of solid | 1,2 g/cm³ |
| heat distortion temperature of solid | 90°C |
| bending strength of solid | 11,2 kg/mm² |
| modulus of bending elasticity of solid | 440 kg/mm² |
| Vicat hardness of solid | 45 |

Said resin is used for impregnating kraft paper cut to the proper length having a thickness of 270 $\mu$m and a weight of 150 g/m². The resin impregnating the paper is based on an aluminum foil having a thickness of 100 $\mu$m which is supported horizontally. The same resin is also applied on the paper which is placed on the aluminum foil to form a resin layer having a thickness of 1 mm. Another virgin paper is placed on the resin layer to have the resin impregnating up into the virgin paper. Said virgin paper is again coated with the same resin composition as defined above. In the same manner the procedure of placing virgin paper on the resin coated paper and coating it with the liquid resin composition is repeated. Finally a pile of six papers being impregnated with the liquid resin composition is produced. After applying the liquid resin composition to the top of the pile and placing an electrolytic copper foil having a thickness of 35 $\mu$m on it, the pile of forced to pass through a pair of rollers being adjusted to a clearance of 1730 $\mu$m, cured in a heat blast first at a temperature of 100°C for 30 minutes and then at 85°C for 10 hours, whereafter the aluminum foil on one side of the pile is removed. The copper clad laminate thus obtained by the batch method has a thickness of about 1,6 mm and comprises layers of resin with a thickness of 20 $\mu$m between each of the paper reinforcements.

Comparative Test

The liquid resin composition prepared according to the Example is applied on the paper of the same kind used in the Example by a curtain-flow method to leave 53% of resin impregnating the paper. Seven sheets of paper impregnated with the resin composition are piled up without applying resin liquid between them, and on one side of the pile an aluminum foil having a thickness of 100 $\mu$m is placed and on the other side of the pile an electrolytic copper foil with a thickness of 35 $\mu$m is placed. Then the pile forced to pass through a pair of rollers having a clearance of 1730 $\mu$m and cured in the same manner as described in the Example. The copper clad laminate thus obtained has a thickness of about 1,6 mm and does not comprise layers of resin between the reinforcements.

In the following table the features of the Example and the comparative test are presented. The test is performed by the method defined in JIS—C—6481.

The bracketed data in the table indicate the condition of pretreatment of the test pieces. From the table it is clear that the Example of the present invention shows a clear advance over the comparative test.

TABLE

|  | EXAMPLE | Comparative Test |
|---|---|---|
| ratio of soaking water (%) | 1,2 | 2,5 |
| ratio of absorbing moisture (%) (C—96/40/95) | 2,3 | 3,8 |
| ratio of mass resistance ($\Omega$-cm) (C—96/23/65) | $9 \times 10^{13}$ | $8 \times 10^{13}$ |
| ratio of mass resistance ($\Omega$-cm) (C—96/40/95) | $8 \times 10^{12}$ | $6 \times 10^{7}$ |
| heat resistance to solder (s) (C—96/23/65) | 30 | 23 |
| heat resistance to solder (s) (C—96/40/95) | 3 | 1 |

**Claims**

1. Copper clad laminates for printing circuit board use on the basis of a laminate comprising a plurality of reinforcements made of cellulosic paper impregnated with a cured resin selected from an unsaturated polyester type resin or epoxy type resin, characterized by a laminate comprising layers of cured resin having a thickness of 1 to 100 $\mu$m existing between and extending substantially over the reinforcements, wherein the cured resin of the layers is the same as that which is impregnating the reinforcements and wherein said layers of cured resin are substantially integral with the adjacent reinforcements, which reinforcements are isolated from each other by said layers of cured resin, obtainable by excessively impregnating each of said reinforcements with a liquid curable resin having a viscosity of 0,005 to 1,5 Pas in an amount of the curable resin of more than 50% by weight based on the weight of the resulting impregnated reinforcement in order to provide a layer of the curable resin on the surface of each of the reinforcements, forming a pile of said excessively impregnated reinforcements and curing the pile while applying low pressure or substantially no pressure.

2. Copper clad laminate according to claim 1, characterized in that the reinforcements are made from linter paper or kraft paper containing predominantly cellulosic fibres.

## Revendications

1. Stratifiés revêtus de cuivre destinés à être utilisés pour des plaques de circuits imprimés sur la base d'un stratifié comprenant une pluralité de renforcements en papier cellulosique imprégné d'une résine durcie choisie parmi une résine du type polyester insaturé ou un résine du type époxy, caractérisés par un stratifié comprenant des couches de résine durcie ayant une épaisseur de 1 à 100 $\mu$m présentes entre les renforcements et s'étendant sensiblement sur ces renforcements, dans lequel la résine durcie des couches est la même que celle qui imprègne les renforcements et dans lequel lesdites couches de résine durcie font sensiblement corps avec les renforcements adjacents, ces renforcements étant isolés l'un de l'autre par lesdites couches de résine durcie, que l'on peut obtenir en imprégnant de façon excédentiare chacun desdits renforcements avec une résine liquide durcissable ayant une viscosité de 0,005 à 1,5 Pas et en une quantité supérieure à 50% en poids basé sur le poids du renforcement imprégné résultant afin que l'on obtienne une couche de résine durcissable sur la surface de chacun des renforcements, en formant un empilement desdits renforcements imprégnés de façon excédentaire et en faisant durcir l'empilement tout en appliquant une faible pression ou sans appliquer sensiblement de pression.

2. Stratifiés revêtus de cuivre suivant la revendication 1, caractérisé par le fait que les renforcements sont en papier de linters ou en papier kraft contenant principalement des fibres cellulosiques.

## Patentansprüche

1. Kupferbeschichtete Laminate für gedruckte Schaltkreisplatten auf der Grundlage eines Laminats, welches eine Vielzahl von Verstärkungen aus Cellulosepapier aufweist, die mit einem gehärteten Harz imprägniert sind, welches aus ungesättigten Polyesterharzen oder Epoxyharzen ausgewählt ist, gekennzeichnet durch ein Laminat, welches gehärtete Harzschichten mit einer Dicke von 1 bis 100 $\mu$m aufweist, die sich zwischen und im wesentlichen über die Verstärkungen erstrecken, wobei das gehärtete Harz der Schichten das gleiche ist, wie jenes, welches die Verstärkungen imprägniert, und wobei die Schichten des gehärteten Harzes im wesentlichen mit den benachbarten Verstärkungen integral sind, welche Verstärkungen durch die Schichten des gehärteten Harzes voneinander isoliert sind, erhältlich durch überschüssiges Imprägnieren jeder der Verstärkungen mit einem flüssigen härtbaren Harz mit einer Viskosität von 0,005 bis 1,5 Pas in einer Menge des härtbaren Harzes von mehr als 50 Gew.-% bezogen auf das Gewicht der sich ergebenden imprägnierten Verstärkung zur Erzeugung einer Schicht des härtbaren Harzes auf der Oberfläche einer jeden Verstärkung, Bilden eines Stapels der überschüssig imprägnierten Verstärkungen und Härten des Stapels unter Anwendung eines geringen oder im wesentlichen keines Druckes.

2. Kupferbeschichtetes Laminat nach Anspruch 1, dadurch gekennzeichnet, daß die Verstärkungen aus Linterpapier oder Kraftpapier bestehen, die überwiegend Cellulosefasern enthalten.

## FIG.1

## FIG.2

## FIG.3